# EUROPEAN PATENT APPLICATION

(11) **EP 1 988 468 A1**
(43) Date of publication of application: **05.11.2008**
(21) Application number: 06714624.1
(22) Date of filing: 24.02.2006
(51) Int. Cl.: G06F 12/16, G06F 12/08, G06F 12/10

(54) **RAM DIAGNOSIS APPARATUS AND RAM DIAGNOSIS METHOD**

(71) Applicant: FUJITSU LIMITED, Kawasaki-shi, Kanagawa 211-8588 (JP)
(72) Inventor: KIYOTA, Naohiro, Kawasaki-shi, Kanagawa, 211-8588 (JP)
(74) Representative: Ward, James Norman
(86) International application number: PCT/JP2006/303485
(87) International publication number: WO 2007/097001

(57) **Abstract**

To more easily and quickly diagnose all bits of a RAM regardless of a size of a mounted main memory. A bit generating unit (110) generates a bit string in which a state bit is added above an address bit indicating an address of a tag RAM (200a). An incrementing unit (140) increments the bit string of the bit generating unit (110) by one at a time. A state selecting unit (150) selects an one of a plurality of kinds of processing referring to the state bit and instructs a writing control unit (160) or a readout control unit (170) to perform an operation corresponding to a state. The writing control unit (160) performs processing for writing in a line of the tag RAM (200a) corresponding to the address bit. The readout control unit (170) performs processing for readout from the line of the tag RAM (200a) corresponding to the address bit and outputs information of this line to an error detecting unit (180). The error detecting unit (180) performs error check for respective lines of the tag RAM (200a).

## Description

### TECHNICAL FIELD

The present invention relates to a RAM diagnosis device and a RAM diagnosis method for diagnosing whether a failure has occurred in a RAM, and, more particularly to a RAM diagnosis device and a RAM diagnosis method that can more easily and quickly diagnose all bits of a RAM regardless of a size of a mounted main memory.

### BACKGROUND WART

In general, for example, when a power supply of a processor in an information processing apparatus is turned on, a failure of a RAM may be diagnosed. In diagnosing the RAM, first, predetermined data for diagnosis is written in the diagnosis object RAM by the processor according to a command of a program. Subsequently, the data for diagnosis written in the RAM is read out according to a command of the program again. It is judged by an error check circuit of hardware whether there is an error in the read-out data for diagnosis. Presence or absence of a failure of the RAM is judged. In other words, if the data for diagnosis read out from the RAM is wrong, it is judged that this RAM is broken. Presence or absence of a failure of the RAM can be confirmed by applying the procedure for writing and readout of the data for diagnosis to all lines of the RAM.

When the data for diagnosis used for such diagnosis of a failure of the RAM is stored in a ROM, during the diagnosis of the RAM, the processor once reads out the data for diagnosis from the ROM and, then, writes the data for diagnosis in the diagnosis object RAM. However, when a size of the diagnosis object RAM increases, a size of the data for diagnosis also increases. Therefore, time from the readout of the data for diagnosis from the ROM until the writing of the data for diagnosis in the RAM by the processor increases. Therefore, for example in Patent Document 1, a technology for directly writing data for diagnosis in a RAM from a ROM not through a processor is disclosed. This makes it possible to reduce time required for failure diagnosis for the RAM.

Patent Document 1: Japanese Patent Application Laid-open No. H5-61780

### DISCLOSURE OF INVENTION

### PROBLEM TO BE SOLVED BY THE INVENTION

Among RAMs, there are those used in a cache in a processor that temporarily stores data of a main memory, for example, a data RAM, a tag RAM (TAG-RAM), and a TLB (Translation Look-aside Buffer)-RAM. A physical address indicating an address of data in the main memory is registered in the tag RAM and the TLB-RAM in the cache. Specifically, a physical address of the cached data on the main memory is registered in the tag RAM. A correspondence relation between virtual addresses used by the program and physical addresses is registered in the TLB-RAM.

In failure diagnosis for these RAMs in the cache, after data for diagnosis is written in the data RAM from the main memory and cached, the cached data for diagnosis is read out. It is judged whether there is an error in the read-out data for diagnosis. According to the caching of the data for diagnosis, contents registered in the tag RAM and the TLB-RAM are read out. It is judged whether read-out registered contents correspond to the data for diagnosis.

Because the number of bits of the physical address registered in the tag RAM and the TLB-RAM can be any number as long as all addresses of the main memory connected to the cache can be represented, the number of bits depends on a size of the main memory. Therefore, when a main memory smaller than a maximum size mountable on an information processing apparatus is mounted, only a physical address with the number of bits smaller than that of a physical address that can be registered in the tag RAM and the TLB-RAM is always registered. High-order bits of the physical address may be always 0.

As a specific example, when the information processing apparatus can be mounted with, for example, a 4 GB (gigabyte) main memory, a memory space of this main memory can be represented by 32 bits. Therefore, a physical address up to 32 bits can be registered in the tag RAM and the TLB-RAM. However, when, for example, a 256 MB (megabyte) main memory is mounted on this information processing apparatus, a memory space of this main memory can be represented by 28 bits. Therefore, high-order 4 bits of a physical address registered in the tag RAM and the TLB-RAM are always 0.

Under such a situation, when failure diagnosis for the tag RAM and the TLB-RAM by the procedure described above is performed, no matter what kind of data for diagnosis is cached from the main memory, high-order bits of a physical address concerning the data for diagnosis are always 0. Therefore, there is a problem in that failure diagnosis for high-order bits of a physical address registered in the tag RAM and the TLB-RAM is impossible.
In other words, in the example described above, because the physical address of the data for diagnosis can be represented by 28 bits, failure diagnosis for high-order 4 bits of the physical address registered in the tag RAM and the TLB-RAM is impossible.

When data for diagnosis is written in the RAM in the cache, the data for diagnosis is written from the main memory according to a command of the program. Therefore, there is a problem in that it takes time to access the main memory. It is necessary to create a program for failure diagnosis taking into account the structure and a state of the cache. Therefore, the program tends to be extremely complicated.

The present invention has been devised in view of such a point and it is an object of the present invention to provide a RAM diagnosis device and a RAM diagnosis method that can more easily and quickly diagnose all bits of a RAM regardless of a size of a mounted main memory.

### MEANS FOR SOLVING PROBLEM

To solve the problems described above and achieve the object, the present invention is a RAM diagnosis device that diagnoses whether a failure has occurred in a RAM.
The RAM diagnosis device includes a generating unit that sequentially generates a state bit indicating any one of states of a plurality of kinds of processing; a selecting unit that selects processing referring to the state bit generated by the generating unit; a writing unit that writes a first data pattern in all areas of the RAM when writing processing is selected by the selecting unit, the writing unit writing a second data pattern obtained by inverting the first data pattern in all the areas of the RAM when the writing processing is selected by the selecting unit next, the first data pattern being binary data; and a detecting unit that reads out the first data pattern or the second data pattern from all the areas of the RAM and detects an error when error check processing is selected by the selecting unit after each of the kinds of writing processing by the writing unit.

In the invention, the generating unit includes a generating unit that generates a bit string in which an address bit indicating a start address of the RAM is added below the state bit; and an incrementing unit that increments the bit string generated by the generating unit by one at a time.

The above invention further includes a judging unit that judges, when a bit string obtained by the incrementing unit is equal to a predetermined bit string, that all kinds of processing indicated by state bits are completed.

In the invention, the selecting unit selects processing from a state bit portion in a bit string obtained by the incrementing unit, and the writing unit writes the first data pattern or the second data pattern in an area of the RAM indicated by an address bit portion in the bit string obtained by the incrementing unit.

In the invention, the selecting unit selects processing from a state bit portion in a bit string obtained by the incrementing unit, and the detecting unit reads out the first data pattern or the second data pattern of an area of the RAM indicated by an address bit portion in the bit string obtained by the incrementing unit, to detect the error.

In the invention, the generating unit sequentially generates a state bit indicating a state of 0-writing processing for writing a first data pattern including only 0 in all the areas of the RAM, a state bit indicating a state of 0-error-check processing for performing error check after the 0-writing processing, a state bit indicating a state of 1-writing processing for writing a second data pattern including only 1 in all the areas of the RAM, and a state bit indicating a state of 1-error-check processing for performing error check after the 1-writing processing.

In the invention, the generating unit further generates a state bit indicating a state of initialization processing for invalidating all the areas of the RAM after the 1-exror-check processing, and the writing unit invalidates all the areas of the RAM when the initialization processing is selected by the selecting unit.

In the invention, the generating unit generates state bits in the 1-writing processing, the 1-error-check processing, the 0-writing processing, and the 0-error-check processing in this order.

In the invention, the detecting unit detects an error in the first data pattern and the second data pattern using parity bits registered in the RAM.

In the invention, the selecting unit includes a first AND circuit that outputs 1 when the state bit indicates writing processing for the first data pattern; a second AND circuit that outputs 1 when the state bit indicates writing processing for the second data pattern; a third AND circuit that outputs 1 when the state bit indicates error check processing for the first data pattern; a fourth AND circuit that outputs 1 when the state bit indicates error check processing for the second data pattern; a first OR circuit that outputs a signal for instructing writing in the RAM when 1 is output from any one of the first AND circuit and the second AND circuit; and a second OR circuit that outputs a signal for instructing readout from the RAM when 1 is output from any one of the third AND circuit and the fourth AND circuit.

The present invention is a RAM diagnosis method for diagnosing whether a failure has occurred in a RAM. The RAM diagnosis method includes a generating step of sequentially generating a state bit indicating any one of states of a plurality of kinds of processing; a selecting step of selecting processing referring to the state bit generated at the generating step; a first writing step of writing a first data pattern in all areas of the RAM when writing processing is selected at the selecting step, the first data pattern being binary data; a first detecting step of reading out the first data pattern written at the first writing step from all the areas of the RAM and detecting an error; a second writing step of writing a second data pattern obtained by inverting the first data pattern in all the areas of the RAM after the first detecting step; and a second detecting step of reading out the second data pattern written at the second writing step from all the areas of the RAM and detecting an error.

### EFFECT OF THE INVENTION

According to the present invention, a state bit indicating any one of states of a plurality of kinds of processing is sequentially generated, processing is selected with reference to the generated state bit, when writing processing is selected, a first data pattern being binary data is written in all the areas of the RAM, when the writing processing is selected next, a second data pattern obtained by inverting the first data pattern is written in all the areas of the RAM, and when error check processing is selected after each of the kinds of writing processing, the first data pattern or the second data pattern is read out from all the areas of the RAM to detect an error. Therefore, it is possible to perform error check after setting bits of all the areas of the RAM to 0 and 1 under the direction of hardware without reading out data from the main memory or using a complicated program. It is possible to more easily and quickly diagnose all bits of the RAM regardless of a size of a mounted main memory.

According to the present invention, a bit string in which an address bit indicating a start address of the RAM is added under state bits and the generated bit string is incremented by one at a time. Therefore, if the bit string is divided into a state bit portion and an address bit portion every time the bit string is incremented, address bits corresponding to addresses of all the areas of the RAM are obtained for one kind of state bit. It is possible to easily perform designation of processing and designation of an area of the RAM as a processing object.

According to the present invention, when the obtained bit string is equal to a predetermined bit string, it is judged that all kinds of processing indicated by the state bits are completed. Therefore, it is possible to directly use the bit string, which is used for designation of processing and designation of an area of the RAM as a processing object, for completion judgment.

According to the present invention, processing is selected from the state bit portion of the obtained bit string and the first data pattern or the second data pattern is written in an area of the RAM indicated by the address bit portion of the obtained bit string. Therefore, while a state bit indicates the writing processing, it is possible to surely write the first data pattern or the second data pattern in all the areas from the start address to the end address of the RAM.

According to the present invention, processing is selected from the state bit portion of the obtained bit string and the first data pattern or the second data pattern in the area of the RAM indicated by the address bit portion of the obtained bit string is read out to detect an error. Therefore, while a state bit indicates the error check processing, it is possible to surely perform error check of the first data pattern or the second data pattern in all the areas from the start address to the end address of the RAM.

According to the present invention, a state bit indicating a state of 0-writing processing for writing a first data pattern including only 0 in all the areas of the RAM, a state bit indicating a state of 0-error-check processing for performing error check after the 0-writing processing, a state bit indicating a state of 1-writing processing for writing a second data pattern including only 1 in all the areas of the RAM, and a state bit indicating a state of 1-error-check processing for performing error check after the 1-writing processing are sequentially generated. Therefore, it is possible to diagnose whether writing and readout of 0 in all the areas of the RAM are normal and diagnose whether writing and readout of 1 in all the areas of the RAM are normal.

According to the present invention, a state bit indicating a state of initialization processing for invalidating all the areas of the RAM after the 1-error-check processing is further generated and, when the initialization processing is selected, all the areas of the RAM are invalidated. Therefore, after the diagnosis of all the areas of the RAM, it is possible to initialize the RAM and perform diagnosis simultaneously with initialization during the start of the RAM and the like included in the cache.

According to the present invention, state bits are generated by the 1-writing processing, the 1-error-check processing, the 0-writing processing, and the 0-error-check processing in this order. Therefore, if an error is not detected, finally, 0 is written in all the areas of the RAM. It is possible to omit initialization of the RAM.

According to the present invention, the first data pattern and the second data pattern are detected by using parity bits registered in the RAM. Therefore, it is possible to perform accurate error check.

According to the present invention, the selecting unit includes the first AND circuit that outputs 1 when a state bit indicates writing processing for the first data pattern, the second AND circuit that outputs 1 when a state bit indicates writing processing for the second data pattern, the third AND circuit that outputs 1 when a state bit indicates error check processing for the first data pattern, the forth AND circuit that outputs 1 when a state bit indicates error check processing for the second data pattern, a first OR circuit that outputs a signal for instructing writing in the RAM when 1 is output from any one of the first AND circuit and the second AND circuit, and the second OR circuit that outputs a signal for instructing readout from the RAM when 1 is output from any one of the third AND circuit and the fourth AND circuit. Therefore, it is possible to select processing from a state bit only with a simple logical operation circuit and more quickly perform accurate diagnosis of the RAM.

### BRIEF DESCRIPTION OF DRAWINGS

[Fig. 1] Fig. 1 is a block diagram showing a main part configuration of an information processing apparatus according to an embodiment of the present invention.
[Fig. 2] Fig. 2 is a diagram showing an example of information registered in a tag RAM.
[Fig. 3] Fig. 3 is a block diagram showing an internal configuration of a RAM diagnosis device according to an embodiment.
[Fig. 4] Fig. 4 is a flowchart of a RAM diagnosis operation according to the embodiment.
[Fig. 5] Fig. 5 is a flowchart of 0-writing processing according to the embodiment.
[Fig. 6] Fig. 6 is a flowchart of 0-error-check processing according to the embodiment.
[Fig. 7] Fig. 7 is a flowchart of 1-writhing processing according to the embodiment.
[Fig. 8] Fig. 8 is a flowchart of 1-error-check processing according to the embodiment.
[Fig. 9] Fig. 9 is a flowchart of initialization processing according to the embodiment.

### EXPLANATIONS OF LETTERS OR NUMERALS

110 bit generating unit
- 120: state-bit output unit
- 130: address-bit output unit
- 140: incrementing unit
- 150: state selecting unit
- 151: inverter
- 152, 153, 154, 155, 156: AND gates
- 157, 158: OR gates
- 160: writing control unit
- 170: readout control unit
- 180: error detecting unit
- 190: completion judging unit

### BEST MODE(S) FOR CARRYING OUT THE INVENTION

An embodiment of the present invention is explained in detail below with reference to the drawings. In the following explanation, a tag RAM in a cache is diagnosed. However, the present invention can also be applied to diagnosis of other RAMs such as a data RAM and a TLB-RAM.

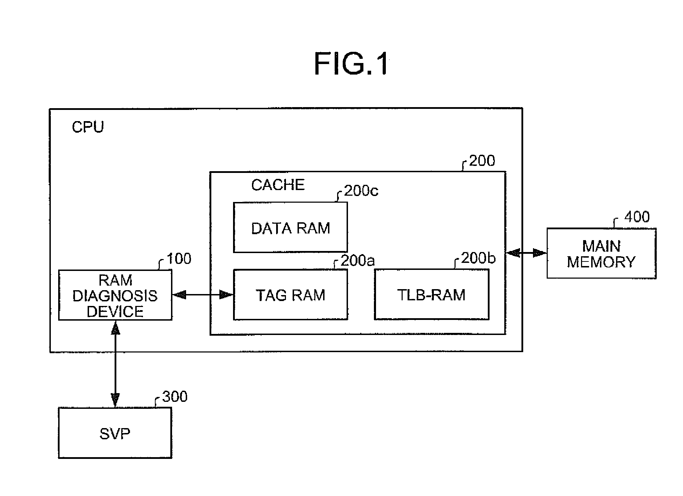

Fig. 1 is a block diagram of a main part configuration of an information processing apparatus including a RAM diagnosis device according to an embodiment of the present invention. The information processing apparatus shown in Fig. 1 includes a cache 200 in a CPU. The cache includes a tag RAM 200a, a TLB-RAM 200b, and a data RAM 200c. A RAM diagnosis device 100 is connected to the tag RAM 200a. A service processor (hereinafter, "SVP") 300 separate from the CPU is connected to the RAM diagnosis device 100.

The cache 200 temporarily stores (caches) data stored in a main memory 400 and realizes an increase in speed of processing when this data is used in the CPU. In this case, the data itself is stored in the data RAM 200c and a physical address of this data in the main memory 400 is stored in the tag RAM 200a.

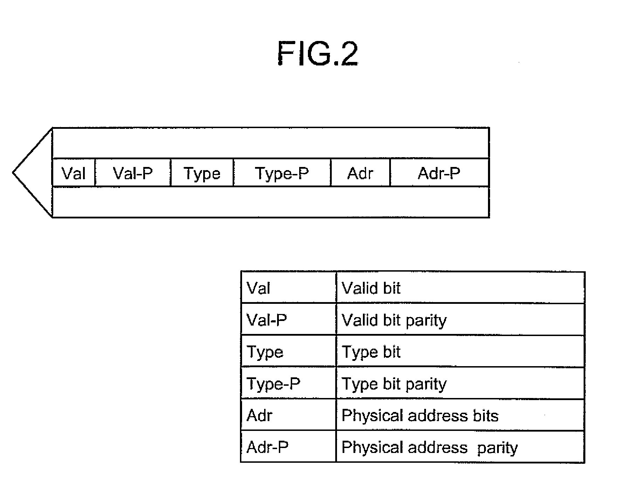

Specifically, for example, information shown in Fig. 2 is registered in respective lines of the tag RAM 200a. In other words, a valid bit (Valid bit) indicating validity/invalidity of data, a parity bit (Valid bit parity) for error check for the valid bit, a type bit indicating a type of the data, a parity bit (Type bit parity) for error check for the type bit, a physical address bit (Physical address bits) indicating a physical address of the data, and a parity bit (Physical address parity) for error check for the physical address bit are registered in the respective lines of the tag RAM 200a. When the CPU reads out desired data and performs processing, the CPU can access the tag RAM 200a, search for a physical address of the desired data, and grasp whether the desired data is cached in the data RAM 200c. A correspondence relation between virtual addresses used in a program and physical addresses is stored in the TLB-RAM 200b.

The RAM diagnosis device 100 diagnoses whether a failure has occurred in the tag RAM 200a in the cache 200. In other words, the RAM diagnosis device 100 sequentially writes 0 and 1 in all bits for storing physical addresses of the tag RAM 200a, performs error check after the writing processing performed every time, and diagnoses presence or absence of a failure in all the bits. A detailed configuration of the RAM diagnosis device 100 is described in detail later.

The SVP 300 is a processor provided independently from the CPU and manages failure diagnosis and the like for the CPU. The SVP 300 instructs the RAM diagnosis device 100 to start initialization of the cache 200 when the information processing apparatus is started. In this initialization, the SVP 300 judges whether diagnosis for a RAM is performed. When diagnosis for the RAM is performed, the SVP 300 instructs the RAM diagnosis device 100 to perform RAM diagnosis simultaneously with the initialization.

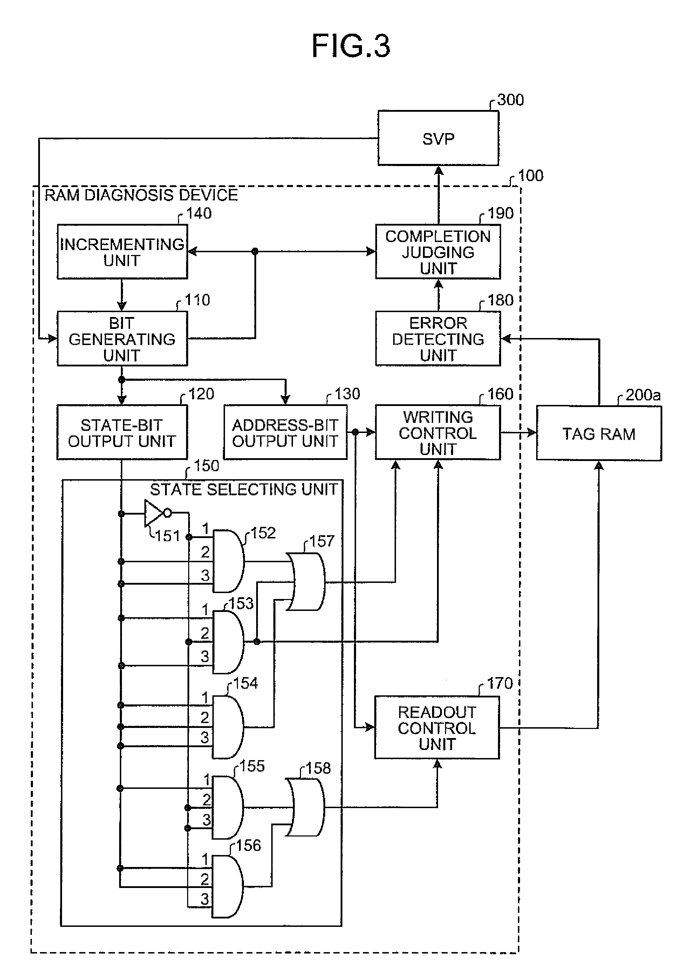

Fig. 3 is a block diagram of an internal configuration of the RAM diagnosis device 100 according to this embodiment. The RAM diagnosis device 100 shown in Fig. 3 includes a bit generating unit 110, a state-bit output unit 120, an address-bit output unit 130, an incrementing unit 140, a state selecting unit 150, a writing control unit 160, a readout control unit 170, an error detecting unit 180, and a completion judging unit 190.

The bit generating unit 110 generates a bit string with the number of bits in which state bits indicating states of diagnosis, initialization, and the like are added above address bits with the number of bits that can represent all the lines of the tag RAM 200a. Specifically, when initialization or diagnosis of the tag RAM 200a is instructed by the SVP 300, the bit generating unit 110 generates a bit string in which a state bit including three bits is added above an address bit in which all bits are 0. The bit generating unit 110 increments the bit string by one at a time according to an instruction from the incrementing unit 140.

When processing executed by the RAM diagnosis device 100 is classified into five states, the state bit is a bit string including three bits corresponding to the respective states. Specifically, processing for writing 0 in the respective lines of the tag RAM 200a (0-writing processing) is represented by "011", error check processing after 0 is written in the tag RAM 200a (0-error-check processing) is represented by "100", processing for writing 1 in the respective lines of the tag RAM 200a (1-writing processing) is represented by "101", error check processing after 1 is written in the tag RAM 200a (1-error-check processing) is represented by "110", and initialization processing for the tag RAM 200a is represented by "111".
In this embodiment, because the processing executed by the RAM diagnosis device 100 is classified into the five states, the state bit includes three bits. However, for example, when the processing can be classified into for states, the state bit only has to include two bits.

Because the state bit is defined as described above, when the SVP 300 instructs initialization of the tag RAM 200a, the bit generating unit 110 generates a bit string in which an address bit, in which all bits are 0, is added following the state bit "111". When the SVP 300 instructs diagnosis of the tag RAM 200a, the bit generating unit 110 generates a bit string in which an address bit, in which all bits are 0, is added following the state bit "011".

The state-bit output unit 120 outputs, every time a bit string is generated by the bit generating unit 110, a state bit including high-order 3 bits of this bit string to the state selecting unit 150. The address-bit output unit 130 outputs, every time a bit string is generated by the bit generating unit 110, an address bit excluding high-order 3 bits of this bit string to the writing control unit 160 and the readout control unit 170. The incrementing unit 140 instructs the bit generating unit 110 to increment a bit string by one at a predetermined period.

The state selecting unit 150 selects any one of the states of the 0-writing processing, the 0-error-check processing, the 1-writing processing, the 1-error-check processing, and the initialization processing referring to the state bit output from the state-bit output unit 120 and instructs the writing control unit 160 or the readout control unit 170 to perform an operation corresponding to each of the states. Specifically, the state selecting unit 150 includes an inverter 151, AND gates 152 to 156, and OR gates 157 and 158.

The inverter 151 inverts the three bits output from the state-bit output unit 120. In other words, the inverter 151 converts 0 of the state bit into 1 and converts 1 into 0.

The AND gates 152 to 156 correspond to the 0-writing processing, the 1-writing processing, the initialization processing, the 0-error-check processing, and the 1-error-check processing, respectively. 1 is output from any one of the AND gates 152 to 156 corresponding to a state indicated by the state bit output from the state-bit output unit 120. In Fig. 3, numbers 1 to 3 shown on input sides of the AND gates 152 to 156 indicate a most significant bit, a second bit, and a third bit of the state bit. Therefore, for example, when the state bit "011" indicating the 0-writhing processing is output from the state-bit output unit 120, "111" obtained by inverting only the most significant bit of the state bit with the inverter 151 is input to the AND gate 152. In this case, "111" is not input to the other AND gates 153 to 156. Therefore, 1 is output from only the AND gate 152. It is seen that a present state is the 0-writing processing.

The same holds true in the other states. In the case of the state bit "101" indicating the 1-writing processing, 1 is output from only the AND gate 153. In the case of the state bit "111" indicating the initialization processing, 1 is output from only the AND gate 154. In the case of the state bit "100" indicating the 0-error-check processing, 1 is output from only the AND gate 155. In the case of the state bit "100" indicating the 1-error-check processing, 1 is output from only the AND gate 156.

When 1 is output from any one of the AND gate 152 corresponding to the 0-writing processing, the AND gate 153 corresponding to the 1-writing processing, and the AND gate 154 corresponding to the initialization processing, the OR gate 157 instructs the writing control unit 160 to perform writing in the tag RAM 200a.

When 1 is output from any one of the AND gate 155 corresponding to the 0-error-chech processing and the AND gate 156 corresponding to the 1-error-check processing, the OR gate 158 instructs the readout control unit 170 to perform readout from the tag RAM 200a.

When writing in the tag RAM 200a is instructed by the OR gate 157, the writing control unit 160 performs processing for writing in a line of the tag RAM 200a corresponding to the address bit output from the address-bit output unit 130. In this case, when 1 is output from the AND gate 153, the writing control unit 160 writes 1. When 0 is output from the AND gate 153, the writing control unit 160 writes 0.

More specifically, during the 0-writing processing and during the initialization processing, the writing control unit 160 writes 0 in all bits of the valid bit, the type bit, and the physical address bit shown in Fig. 2 and writes a value (here, 1) for not causing an error in respective bits to be error-checked in all the parity bits. During the 1-writing processing, the writing control unit 160 writes 1 in all bits of the valid bit, the type bit, and the physical address bit and writes a value (here, 0) for not causing an error in respective bits to be error-checked in all the parity bits.

Here, 0 is written in all the bits without distinguishing the 0-writing processing and the initialization processing. However, when 1 is output from the AND gate 154 to the writing control unit 160 (i.e., the initialization processing is performed), 0 can be written in only the valid bit and 1 can be written in the parity bit of the valid bit to perform only processing for invalidating the lines.

When readout from the tag RAM 200a is instructed by the OR gate 158, the readout control unit 170 performs processing for readout from a line of the tag RAM 200a corresponding to the address bit output from the address-bit output unit 130 and causes the tag RAM 200a to output information concerning this line to the error detecting unit 180. In other words, when the state bit indicates the 0-error-check processing or the 1-error-check processing, the readout control unit 170 causes the tag RAM 200a to sequentially output information concerning the lines of the tag RAM 200a to the error detecting unit 180.

When the information concerning the respective lines is output from the tag RAM 200a, the error detecting unit 180 performs error check of the valid bit, the type bit, and the physical address bit using the parity bits of the respective lines and notifies a result of the error check to the completion judging unit 190. The error check by the error detecting unit 180 is performed after the 0-writing processing and after the 1-writing processing. Therefore, during error check after the 0-writing processing, if all bits of the respective lines are 0, there is no error in writing of 0 in and readout of 0 from the tag RAM 200a. During error check after the 1-writing processing, if all bits of the respective lines are 1, there is no error in writing of 1 in and readout of 1 from the tag RAM 200a.

When all bits of the bit string generated by the bit generating unit 110 is 1 and absence of an error is notified from the error detecting unit 180, the completion judging unit 190 notifies the SVP 300 that the initialization of the tag RAM 200a is completed. In other words, when the bit string generated by the bit generating unit 110 is incremented by one at a time, the state bit is finally "111", and all the address bits are 1, the completion judging unit 190 judges that all the lines of the tag RAM 200a are initialized, confirms that an error is not detected, and notifies completion of the initialization to the SVP 300.

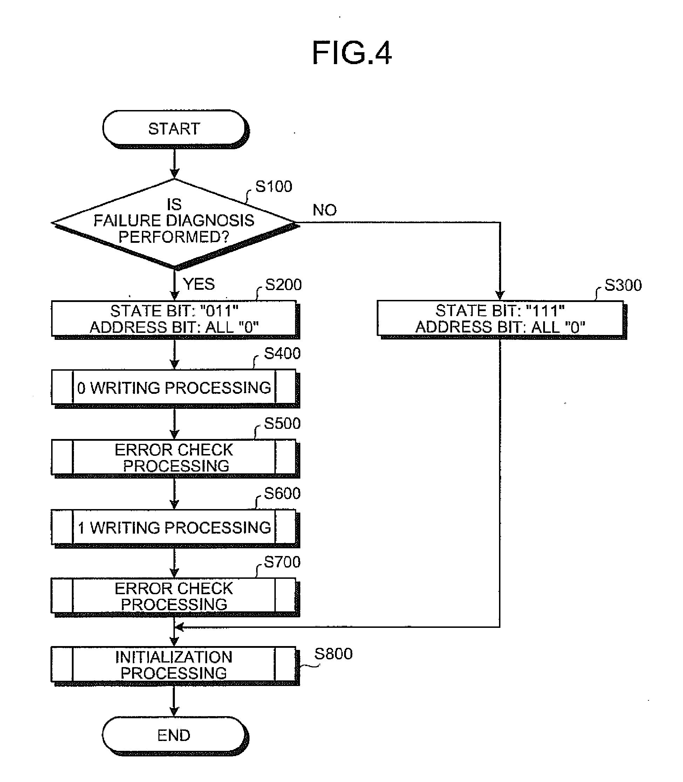

Subsequently, a diagnosis operation for the tag RAM 200a by the RAM diagnosis device 100 configured as described above is explained referring to flowcharts shown in Figs. 4 to 9.

First, during the start or the like of the information processing apparatus, it is judged by the SVP 300 whether diagnosis of the tag RAM 200a is performed (step S100). This judgment is performed based on, for example, whether a user selects a diagnosis inhibition mode for not performing diagnosis. As a result of this judgment, when diagnosis of the tag RAM 200a is performed ("Yes" at step S100), the bit generating unit 110 is notified to that effect. A bit string with high-order 3 bits of a state bit set as "011" and all address bits lower in order than the state bit set as 0 is generated by the bit generating unit 110 (step S200). The 0-writing processing (step S400), the 0-error-check processing (step S500), the 1-writing processing (step S600), the 1-error-check processing (step S700), and the initialization processing (step S800) are sequentially executed by the RAM diagnosis device 100.

On the other hand, as a result of the judgment at step S100, when diagnosis of the tag RAM 200a is not performed ("No" at step S100), the bit generating unit 110 is notified to that effect. A bit string with high-order 3 bits of a state bit set as "111" and all address bits lower in order than the state bit set as 0 is generated by the bit generating unit 110 (step S300). Then, only the initialization processing (step S800) is executed by the RAM diagnosis device 100. Assuming that diagnosis of the tag RAM 200a is performed, the 0-writing processing (step S400), the 0-error-check processing (step S500), the 1-writing processing (step S600), the 1-error-check processing (step S700), and the initialization processing (step S800) are explained in order.

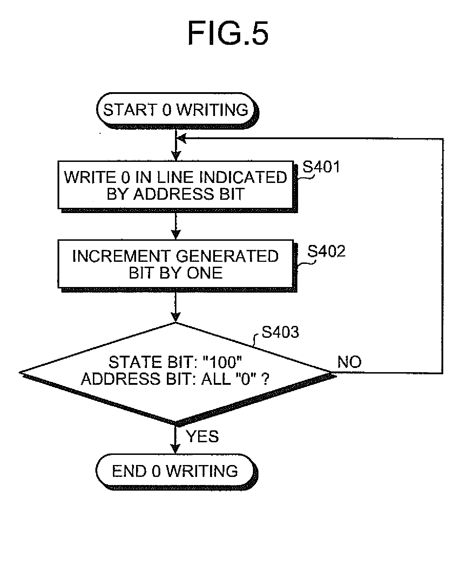

First, the 0-writing processing (step S400) is explained referring to Fig. 5. During the start of the 0-writing processing, a bit string in which high-order 3 bits are "011" and all bits lower in order than the high-order 3 bits are 0 is generated by the bit generating unit 110. This bit string is output to the state-bit output unit 120, the address-bit output unit 130, and the completion judging unit 190. Because all the bits of the bit string are not 1, it is not judged by the completion judging unit 190 that initialization is completed.

When the bit string is output to the state-bit output unit 120, the high-order 3 bits "011" is output from the state-bit output unit 120 to the state selecting unit 150. The respective bits or bits obtained by inverting the bits with the inverter 151 are input to the AND gates 152 to 156. Only a most significant bit in state bit "011" is inverted by the inverter 151. Consequently, because all inputs to the AND gates are 1, 1 is output from only the AND gate 152 and 0 is output from the AND gates 153 to 156. Therefore, because writing in the tag RAM 200a is instructed from the OR gate 157 to the writing control unit 160 and 0 is output from the AND gate 153 to the writing control unit 160, 0 is written in the tag RAM 200a.

When the bit string is output to the address-bit output unit 130, a bit string excluding the high-order 3 bits (here, a bit string in which all bits are 0) is output from the address-bit output unit 130 to the writing control unit 160 and the readout control unit 170. 0 is written in a line of the tag RAM 200a indicated by the bit string (address bits), which is output from the address-bit output unit 130, by the writing control unit 160 instructed to perform writing by the OR gate 157 (step S401). In other words, 0 is written in all bits of the valid bit, the type bit, and the physical address bit indicated by an address in which all bits are 0.

On the other hand, it is instructed by the incrementing unit 140 to increment generated bits by one and a bit string in which high-order 3 bits are "011", a least significant bit is 1, and all remaining bits are 0 is generated by the bit generating unit 110 (step S402). In the same manner as described above, a state bit is output to the state selecting unit 150 and an address bit is output to the writing control unit 160 and the readout control unit 170. In this case, it is detected by the state selecting unit 150 whether the state bit is "100" (step S403). If the state bit is "100", the 0-writing processing is finished. However, because the state bit is "011" ("No" at step S403), the 0-writhing processing is continuously executed.

In other words, an address bit in which a least significant bit is 1 and all remaining bits are 0 is output from the address-bit output unit 130 to the writing control unit 160. 0 is written in a line of the tag RAM 200a corresponding to the address bit by the writing control unit 160.

After that, while a bit string generated by the bit generating unit 110 is incremented by one at a time, 0 is written in a line indicated by an address bit increased by one at a time as long as high-order 3 bits are "011". When a bit string in which high-order 3 bits are "011" and all bits lower in order than the high-order 3 bits are 1 is generated by the bit generating unit 110 and 0 is written in a line corresponding to an address bit in which all bits are 1, 0 is written in all the lines of the tag RAM 200a.

After 0 is written in the line of the tag RAM 200a corresponding to the address bit in which all bits are 1, when a bit string generated by the bit generating unit 110 is incremented by one, a bit string in which high-order 3 bits are "100" and all bits lower in order than the high-order 3 bits are 0 is generated. Therefore, it is detected by the state selecting unit 150 that a state bit is "100" ("Yes" at step S403) and the 0-writing processing is completed.

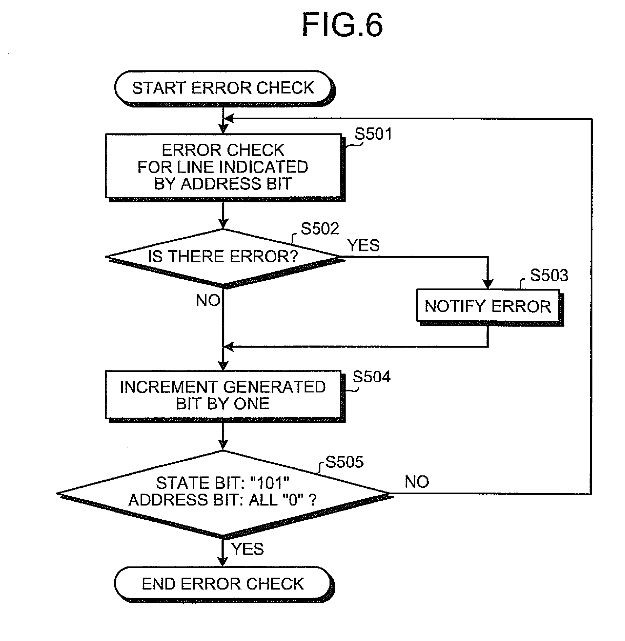

The 0-error-check processing (step S500) is explained referring to Fig. 6. When the 0-writing processing is completed, a bit string in which high-order 3 bits are "100" and all bits lower in order than the high-order 3 bits are 0 is generated by the bit generating unit 110. This bit string is output to the state-bit output unit 120, the address-bit output unit 130, and the completion judging unit 190. Because all the bits of the bit string are not 1, it is not judged by the completion judging unit 190 that initialization is completed.

When the bit string is output to the state-bit output unit 120, the high-order 3 bits "100" are output from the state-bit output unit 120 to the state selecting unit 150. The respective bits or bits obtained by inverting the bits with the inverter 151 are input to the AND gates 152 to 156. Second and third bits in the state bit "100" are inverted by the inverter 151. Consequently, because all inputs to the AND gates are 1, 1 is output from only the AND gate 155 and 0 is output from the AND gates 152 to 154 and 156. Therefore, readout from the tag RAM 200a is instructed from the OR gate 158 to the readout control unit 170.

When the bit string is output to the address-bit output unit 130, a bit string excluding high-order 3 bits (here, a bit sting in which all bits are 0) is output from the address-bit output unit 130 to the writing control unit 160 and the readout control unit 170. Then, readout of information from a line of the tag RAM 200a indicated by an address bit, which is output from the address-bit output unit 130, to the error detecting unit 180 is executed by the readout control unit 170 instructed to perform readout by the OR gate 158. In other words, information of a line indicated by an address in which all bits are 0 is output to the error detecting unit 180.

When the information is output to the error detecting unit 180, error check for a valid bit, a type bit, and a physical address bit is performed by the error detecting unit 180 by using parity bits (step S501). It is judged whether there is an error in the information of the line output from the tag RAM 200a (step S502). When there is an error, the completion judging unit 190 is notified to that effect (step S503).

On the other hand, an instruction for incrementing a generated bit by one at a time is output from the incrementing unit 140. A bit string in which high-order 3 bits are "100", a least significant bit is 1, and all remaining bits are 0 is generated by the bit generating unit 110 (step S504). In the same manner as described above, a state bit is output to the state selecting unit 150 and an address bit is output to the writing control unit 160 and the readout control unit 170. In this case, it is detected by the state detecting unit 150 whether the state bit is "101" (step S505). If the state bit is "101", the 0-error-check processing is finished. However, because the state bit is "100" ("No" at step S505), the 0-error-check processing is continuously executed.

In other words, an address bit in which a least significant bit is 1 and all remaining bits are 0 is output from the address-bit output unit 130 to the readout control unit 170. Readout of information from a line of the tag RAM 200a corresponding to the address bit to the error detecting unit 180 is executed by the readout control unit 170. Error check for the read-out information of the line is performed by the error detecting unit 180.

After that, while a bit string generated by the bit generating unit 110 is incremented by one at a time, error check for a line indicated by an address bit increased by one at a time is performed as long as high-order 3 bits are "100". When a bit string in which high-order 3 bits are "100" and all bits lower in order than the high-order 3 bits are 1 is generated by the bit generating unit 110 and error check for a line corresponding to an address bit in which all bits are 1 is performed, error check at the time when 0 is written in all the lines of the tag RAM 200a is performed.

After the error check for the line of the tag RAM 200a corresponding to the address bit in which all bits are 1 is performed, when a bit string generated by the bit generating unit 110 is incremented by one, a bit string in which high-order 3 bits are "101" and all bits lower in order than the high-order 3 bits are 0 is generated. Therefore, it is detected by the state selecting unit 150 that a state bit is "101" ("Yes" at step S505) and the 0-error-check processing is completed.

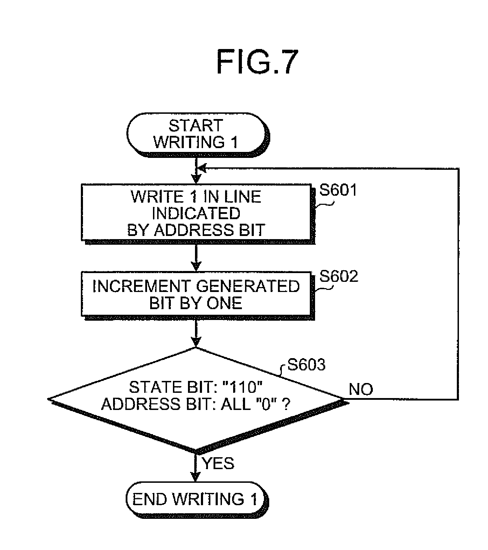

The 1-writing processing (step S600) is explained referring to Fig. 7. When the 0-error-check processing is completed, a bit string in which high-order 3 bits are "101" and all bits lower in order than the nigh-order 3 bits are 0 is generated by the bit generating unit 110. This bit string is output to the state-bit output unit 120, the address-bit output unit 130, and the completion judging unit 190. Because all the bits of the bit string are not 1, it is not judged by the completion judging unit 190 that initialization is completed.

When the bit string is output to the state-bit output unit 120, the high-order 3 bits "101" are output from the state-bit output unit 120 to the state selecting unit 150. The respective bits or bits obtained by inverting the bits with the inverter 151 are input to the AND gates 152 to 156. Only a second bit in the state bit "101" is inverted by the inverter 151. Consequently, because all inputs to the AND gates are 1, 1 is output from only the AND gate 153 and 0 is output from the AND gates 152 and 154 to 156. Therefore, writing in the tag RAM 200a is instructed from the OR gate 157 to the writing control unit 160 and 1 is output from the AND gate 153 to the writing control unit 160. Consequently, 1 is written in the tag RAM 200a.

On the other hand, an instruction for incrementing a generated bit by one at a time is output from the incrementing unit 140. A bit string in which high-order 3 bits are "101", a least significant bit is 1, and all remaining bits are 0 is generated by the bit generating unit 110 (step S602). In the same manner as described above, a state bit is output to the state selecting unit 150 and an address bit is output to the writing control unit 160 and the readout control unit 170. In this case, it is detected by the state detecting unit 150 whether the state bit is "110" (step S603). If the state bit is "110", the 1-writing processing is finished. However, because the state bit is "101" ("No" at step S603), the 1-writing processing is continuously executed.

In other words, an address bit in which a least significant bit is 1 and all remaining bits are 0 is output from the address-bit output unit 130 to the writing control unit 160. 1 is written in a line of the tag RAM 200a corresponding to the address bit by the writing control unit 160.

After that, while a bit string generated by the bit generating unit 110 is incremented by one at a time, 1 is written in a line indicated by an address bit increased by one at a time as long as high-order 3 bits are "101". When a bit string in which high-order 3 bits are "101" and all bits lower in order than the high-order 3 bits are 1 is generated by the bit generating unit 110 and 1 is written in a line corresponding to an address bit in which all bits are 1, 1 is written in all the lines of the tag RAM 200a.

After 1 is written in the line of the tag RAM 200a corresponding to the address bit in which all bits are 1, when a bit string generated by the bit generating unit 110 is incremented by one, a bit string in which high-order 3 bits are "110" and all bits lower in order than the high-order 3 bits are 0 is generated. Therefore, it is detected by the state selecting unit 150 that a state bit is "110" ("Yes" at step S603) and the 1-writing processing is completed.

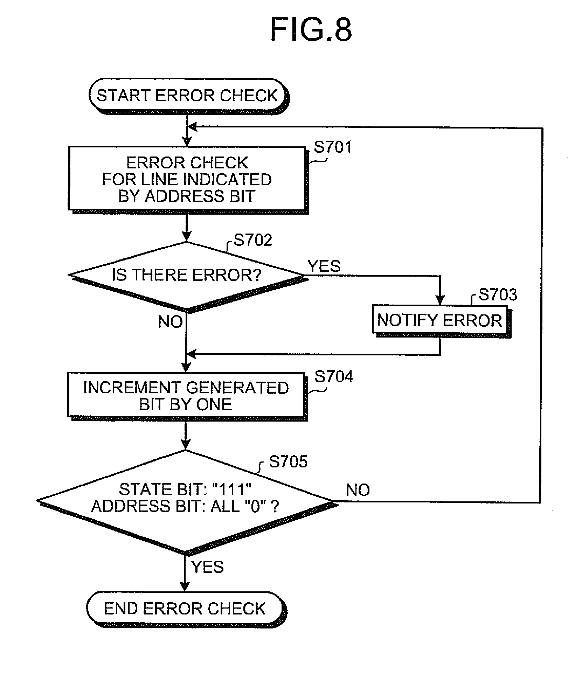

The 1-error-check processing (step S700) is explained referring to Fig. 8. When the 1-writing processing is completed, a bit string in which high-order 3 bits are "110" and all bits lower in order than the high-order 3 bits are 0 is generated by the bit generating unit 110. This bit string is output to the state-bit output unit 120, the address-bit output unit 130, and the completion judging unit 190. Because all the bits of the bit string are not 1, it is not judged by the completion judging unit 190 that initialization is completed.

When the bit string is output to the state-bit output unit 120, the high-order 3 bits "110" are output from the state-bit output unit 120 to the state selecting unit 150. The respective bits or bits obtained by inverting the bits with the inverter 151 are input to the AND gates 152 to 156. Only a third bit in the state bit "110" is inverted by the inverter 151. Consequently, because all inputs to the AND gates are 1, 1 is output from only the AND gate 156 and 0 is output from the AND gates 152 to 155. Therefore, readout from the tag RAM 200a is instructed from the OR gate 158 to the readout control unit 170.

When the bit string is output to the address-bit output unit 130, a bit string excluding high-order 3 bits (here, a bit sting in which all bits are 0) is output from the address-bit output unit 130 to the writing control unit 160 and the readout control unit 170. Then, readout of information from a line of the tag RAM 200a indicated by an address bit, which is output from the address-bit output unit 130, to the error detecting unit 180 is executed by the readout control unit 170 instructed to perform readout by the OR gate 158. In other words, information of a line indicated by an address in which all bits are 0 is output to the error detecting unit 180.

When the information is output to the error detecting unit 180, error check for a valid bit, a type bit, and a physical address bit is performed by the error detecting unit 180 by using parity bits (step S701). It is judged whether there is an error in the information of the line output from the tag RAM 200a (step S702). When there is an error, the completion judging unit 190 is notified to that effect (step S703).

On the other hand, an instruction for incrementing a generated bit by one at a time is output from the incrementing unit 140. A bit string in which high-order 3 bits are "110", a least significant bit is 1, and all remaining bits are 0 is generated by the bit generating unit 110 (step S704). In the same manner as described above, a state bit is output to the state selecting unit 150 and an address bit is output to the writing control unit 160 and the readout control unit 170. In this case, it is detected by the state detecting unit 150 whether the state bit is "111" (step S705). If the state bit is "111", the 1-error-check processing is finished. However, because the state bit is "110" ("No" at step S705), the 1-error-check processing is continuously executed.

In other words, an address bit in which a least significant bit is 1 and all remaining bits are 0 is output from the address-bit output unit 130 to the readout control unit 170. Readout of information from a line of the tag RAM 200a corresponding to the address bit to the error detecting unit 180 is executed by the readout control unit 170. Error check for the read-out information of the line is performed by the error detecting unit 180.

After that, while a bit string generated by the bit generating unit 110 is incremented by one at a time, error check for a line indicated by an address bit increased by one at a time is performed as long as high-order 3 bits are "110". When a bit string in which high-order 3 bits are "110" and all bits lower in order than the high-order 3 bits are 1 is generated by the bit generating unit 110 and error check for a line corresponding to an address bit in which all bits are 1 is performed, error check at the time when 1 is written in all the lines of the tag RAM 200a is performed.

After the error check for the line of the tag RAM 200a corresponding to the address bit in which all bits are 1 is performed, when a bit string generated by the bit generating unit 110 is incremented by one, a bit string in which high-order 3 bits are "111" and all bits lower in order than the high-order 3 bits are 0 is generated. Therefore, it is detected by the state selecting unit 150 that a state bit is "111" ("Yes" at step S705) and the 1-error-check processing is completed.

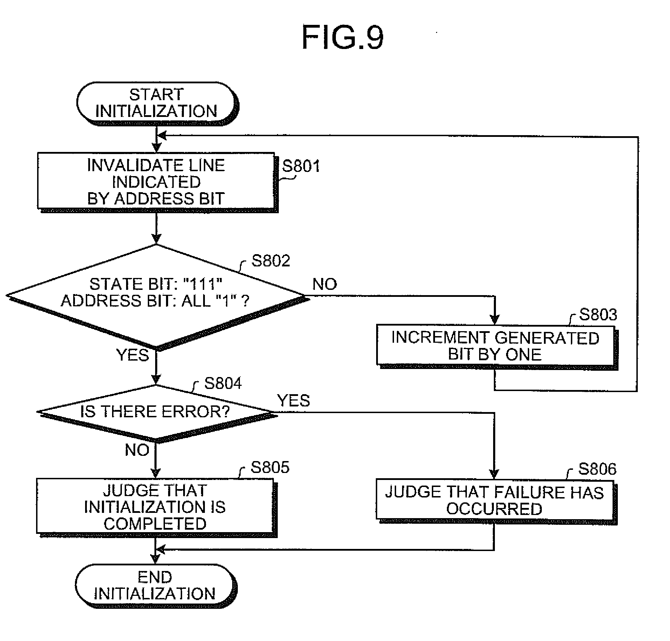

The initialization processing (step S800) is explained referring to Fig. 9. When the 1-error-check processing is completed, a bit string in which high-order 3 bits are "111" and all bits lower in order than the high-order 3 bits are 0 is generated by the bit generating unit 110. This bit string is output to the state-bit output unit 120, the address-bit output unit 130, and the completion judging unit 190. Because all the bits of the bit string are not 1, it is not judged by the completion judging unit 190 that initialization is completed.

When the bit string is output to the state-bit output unit 120, the high-order 3 bits "111" are output from the state-bit output unit 120 to the state selecting unit 150. The respective bits or bits obtained by inverting the bits with the inverter 151 are input to the AND gates 152 to 156. All the bits in the state bit "111" are input without being inverted. Consequently, because all inputs to the AND gates are 1, 1 is output from only the AND gate 154 and 0 is output from the AND gates 152, 153, 155, and 156. Therefore, writing in the tag RAM 200a is instructed from the OR gate 158 to the writing control unit 160 and 0 is output from the AND gate 153 to the writing control unit 160. 0 is written in the tag RAM 200a. In this case, as described above, 1 can be directly output from the AND gate 154 to the writing control unit 160 and writing can be performed by distinguishing the 0-writing processing and the initialization processing.

When the bit string is output to the address-bit output unit 130, a bit string excluding high-order 3 bits (here, a bit sting in which all bits are 0) is output from the address-bit output unit 130 to the writing control unit 160 and the readout control unit 170. Then, a line of the tag RAM 200a indicated by an address bit, which is output from the address-bit output unit 130, is invalidated by the writing control unit 160 instructed to perform readout by the OR gate 157 (S801). In other words, 0 is written in a valid bit of a line indicated by an address in which all bits are 0. 0 can also be written in a type bit and a physical address bit other than the valid bid.

In a process of this initialization processing, it is detected by the completion judging unit 190 whether all bits of a bit string generated by the bit generating unit 110 are 1 (step S802). When all the bits of the bit string are 1, presence or absence of a failure is finally judged. Because the state bit is "111" but all bits of the address bit are not 1 ("No" at step S802), invalidation of a line is continuously performed.

In other words, when an instruction for incrementing generated bits by one is output from the incrementing unit 140 and a bit string in which high-order 3 bits are "111", a least significant bit is 1, and all remaining bits are 0 is generated by the bit generating unit 110 (step S803). In the same manner as described above, the state bit is output to the state selecting unit 150 and the address bit is output to the writing control unit 160 and the readout control unit 170. A line of the tag RAM 200a corresponding to the address bit is invalidated by the writing control unit 160.

After that, while a bit string generated by the bit generating unit 110 is incremented by one at a time, 1 is written in a line indicated by an address bit increased by one at a time as long as high-order 3 bits are "111". When a bit string in which high-order 3 bits are "111" and all bits lower in order than the high-order 3 bits are 1 is generated by the bit generating unit 110 and a line corresponding to an address bit in which all bits are 1 is invalidated, all the lines of the tag RAM 200a are invalidated and initialized.

Moreover, at this point, all the bits of the bit string generated by the bit generating unit 110 are 1. Therefore, it is judged by the completion judging unit 190 whether initialization of the tag RAM 200a is completed. In other words, it is judged at step S804 whether occurrence of an error is notified from the error detecting unit 180 in the 0-error-check processing (step S500) and the 1-error-check processing (step S700). When there is no notification of an error ("No" at step S804), it is judged that initialization of the tag RAM 200a is completed (step S805) and completion of the initialization is notified from the completion judging unit 190 to the SVP 300. When there is notification of an error ("Yes" at step S804), it is judged that a failure has occurred in the tag RAM 200a (step S806) and it is notified from the completion judging unit 190 to the SVP 300 that the failure has occurred in the tag RAM 200a. When the failure has occurred in the tag RAM 200a, processing for notifying the user of a message that the failure has occurred is performed by the SVP 300.

As described above, according to this embodiment, diagnosis and access to the main memory by a program are not performed, writing of 0 in all the lines of the tag RAM, readout of all the lines, and error check are performed, and, then, writing of 1 in all the lines of the tag RAM, readout of all the lines, and error check are performed by hardware. Therefore, it is possible to more easily and quickly diagnose all bits of the RAM in the cache regardless of a size of a mounted main memory.

In the embodiment described above, when pipeline control is performed, prior to each of the 0-writing processing, the 0-error-check processing, the 1-writing processing, the 1-error-check processing, and the initialization processing, for example, it is sufficient to request a not-shown pipeline control unit to perform invalidation in the same manner as that in RAM initialization in the past and perform the processing when this invalidation request acquires priority of a pipeline.

In the embodiment, the 0-writing processing is executed earlier than the 1-writing processing. However, the 1-writing processing can be executed earlier. In this case, because the 0-writing processing is executed later, the initialization processing is unnecessary. The states of processing can be reduced to four and the state bit can be reduced to two bits. The 1-writing processing and the 0-writing processing in the embodiment are processing that can be executed by diverting an initialization circuit that is used only in initialization of a RAM in the past. Therefore, a size of a circuit added to perform diagnosis of the RAM can be small. Therefore, an increase in a circuit size due to the RAM diagnosis device according to the present invention is controlled to be a minimum.

Moreover, in the embodiment, as the 0-writing processing and the 1-writing processing, 0 or 1 is written in all the lines of the tag RAM at the same time. However, to diagnose all bits of all the lines of the tag RAM, both 0 and 1 only have to be written in each of all the bits during an entire diagnosis operation. Therefore, inverted arbitrary data patterns can be written in first writing processing and second writing processing and error check processing can be performed after the first writing processing and the second writing processing.

It is possible to specify which of the RAMs is broken by, rather than performing diagnosis for only the tag RAM, performing the same diagnosis for the TLB-RAM and the data RAM and changing a signal for notifying an error depending on the RAMs.

### INDUSTRIAL APPLICABILITY

The present invention can be applied when all bits of a RAM are more easily and quickly diagnosed regardless of a size of a mounted main memory.

## Claims

1. A RAM diagnosis device that diagnoses whether a failure has occurred in a RAM, the RAM diagnosis device comprising:
a generating unit that sequentially generates a state bit indicating any one of states of a plurality of kinds of processing;
a selecting unit that selects processing referring to the state bit generated by the generating unit;
a writing unit that writes a first data pattern in all areas of the RAM when writing processing is selected by the selecting unit, the writing unit writing a second data pattern obtained by inverting the first data pattern in all the areas of the RAM when the writing processing is selected by the selecting unit next, the first data pattern being binary data; and
a detecting unit that reads out the first data pattern or the second data pattern from all the areas of the RAM and detects an error when error check processing is selected by the selecting unit after each of the kinds of writing processing by the writing unit.

2. The RAM diagnosis device according to claim 1, wherein the generating unit includes:
a generating unit that generates a bit string in which an address bit indicating a start address of the RAM is added below the state bit; and
an incrementing unit that increments the bit string generated by the generating unit by one at a time.

3. The RAM diagnosis device according to claim 2, further comprising a judging unit that judges, when a bit string obtained by the incrementing unit is equal to a predetermined bit string, that all kinds of processing indicated by state bits are completed.

4. The RAM diagnosis device according to claim 2, wherein
the selecting unit selects processing from a state bit portion in a bit string obtained by the incrementing unit, and
the writing unit writes the first data pattern or the second data pattern in an area of the RAM indicated by an address bit portion in the bit string obtained by the incrementing unit.

5. The RAM diagnosis device according to claim 2, wherein the selecting unit selects processing from a state bit portion in a bit string obtained by the incrementing unit, and
the detecting unit reads out the first data pattern or the second data pattern of an area of the RAM indicated by an address bit portion in the bit string obtained by the incrementing unit, to detect the error.

6. The RAM diagnosis device according to claim 1, wherein the generating unit sequentially generates a state bit indicating a state of 0-writing processing for writing a first data pattern including only 0 in all the areas of the RAM, a state bit indicating a state of 0-error-check processing for performing error check after the 0-writing processing, a state bit indicating a state of 1-writing processing for writing a second data pattern including only 1 in all the areas of the RAM, and a state bit indicating a state of 1-error-check processing for performing error check after the 1-writing processing.

7. The RAM diagnosis device according to claim 6, wherein
the generating unit further generates a state bit indicating a state of initialization processing for invalidating all the areas of the RAM after the 1-error-check processing, and
the writing unit invalidates all the areas of the RAM when the initialization processing is selected by the selecting unit.

8. The RAM diagnosis device according to claim 6, wherein the generating unit generates state bits in the 1-writing processing, the 1-error-check processing, the 0-writing processing, and the 0-error-check processing in this order.

9. The RAM diagnosis device according to claim 1, wherein the detecting unit detects an error in the first data pattern and the second data pattern using parity bits registered in the RAM.

10. The RAM diagnosis device according to claim 1, wherein the selecting unit includes:
a first AND circuit that outputs 1 when the state bit indicates writing processing for the first data pattern;
a second AND circuit that outputs 1 when the state bit indicates writing processing for the second data pattern;
a third AND circuit that outputs 1 when the state bit indicates error check processing for the first data pattern;
a fourth AND circuit that outputs 1 when the state bit indicates error check processing for the second data pattern;
a first OR circuit that outputs a signal for instructing writing in the RAM when 1 is output from any one of the first AND circuit and the second AND circuit; and
a second OR circuit that outputs a signal for instructing readout from the RAM when 1 is output from any one of the third AND circuit and the fourth AND circuit.

11. A RAM diagnosis method for diagnosing whether a failure has occurred in a RAM, the RAM diagnosis method comprising:
a generating step of sequentially generating a state bit indicating any one of states of a plurality of kinds of processing;
a selecting step of selecting processing referring to the state bit generated at the generating step;
a first writing step of writing a first data pattern in all areas of the RAM when writing processing is selected at the selecting step, the first data pattern being binary data;
a first detecting step of reading out the first data pattern written at the first writing step from all the areas of the RAM and detecting an error;
a second writing step of writing a second data pattern obtained by inverting the first data pattern in all the areas of the RAM after the first detecting step; and
a second detecting step of reading out the second data pattern written at the second writing step from all the areas of the RAM and detecting an error.
